# EUROPÄISCHE PATENTANMELDUNG

(11) **EP 3 648 152 A1**
(43) Veröffentlichungstag der Anmeldung: **06.05.2020**
(21) Anmeldenummer: 19206746.0
(22) Anmeldetag: 01.11.2019
(51) Int. Cl.: H01L 21/67, H01L 21/68, B25J 9/16, B25J 9/00, H01L 21/677

(54) **VERFAHREN ZUM ANLERNEN ODER KONTROLLIEREN EINES ROBOTERS SOWIE HIERFÜR VERWENDETES SYSTEM**

(30) Priorität: 08.11.2018 EP 18205111; 01.11.2018 EP 18203938
(71) Anmelder: Integrated Dynamics Engineering GmbH, 65479 Raunheim (DE)
(72) Erfinder: BIRKNER, Andreas, 07743 Jena (DE)
(74) Vertreter: Blumbach · Zinngrebe Patentanwälte PartG mbB

(57) **Zusammenfassung**

Verfahren zum Anlernen oder Kontrollieren eines Roboters zum Bewegen eines Wafers oder einer Maske, wobei zumindest eine Kamera verwendet wird, die die Bewegung des Roboters oder des Wafers oder der Maske aufnimmt. Das Verfahren wird insbesondere für das Teach-In eines Roboters mit einem Endeffektor zum Transportieren eines Wafers bzw. einer Maske verwendet.

## Beschreibung

### Gebiet der Erfindung

Die Erfindung betrifft ein Verfahren zum Anlernen oder Kontrollieren eines Roboters zum Bewegen eines Wafers oder einer Maske sowie ein zur Ausführung des Verfahrens ausgebildetes System. Die Erfindung betrifft also insbesondere ein Verfahren, welches zum Anlernen oder Kontrollieren eines Roboters zur Prozessierung von Halbleiterbauelementen verwendet wird.

### Hintergrund der Erfindung

In Anlagen zur Prozessierung von Halbleiterbauelementen werden Roboter verwendet. Insbesondere ist es gängig, dass mittels eines Roboters, welcher einen sogenannten Endeffektor zum Greifen und Ablegen eines Wafers oder einer Maske hat, die zu prozessierenden Teile zu Bearbeitungsstationen bewegt werden. Derartige Roboter bewegen den Endeffektor in der Regel in mehreren Raumrichtungen und es ist bei einer Anlage zur Prozessierung von Halbleiterbauelementen nötig, den Roboter anzulernen, also die Trajektorie einer Bewegungskurve einzuspeichern.

Bei dem sogenannten "Teach-in" wird ein Roboter mit einem Bewegungsablauf angelernt und/oder mechanisch justiert, welchen er sodann im Betrieb der Anlage weiter ausführt. Insbesondere wird beim Teach-In eine Zielposition angelernt, in welcher das Substrat vom Roboter abgelegt wird. Das Teach-in wird bei vielen Robotern manuell bei angeschalteten Motorachsen durchgeführt. Zumeist erfolgt der Teach-in-Vorgang unter optischer Kontrolle durch einen Bediener und die Bewegungskurve wird durch eine Vielzahl kleinerer Einzelschritte, insbesondere der Radial- und Theta-Bewegungen, durchgeführt. Oft sind dabei zwei Bediener erforderlich, da beim Teach-in-Vorgang zwei oder mehr Richtungen oder Freiheitsgrade optisch überwacht werden müssen, um Kollisionen zu vermeiden.

Bei Fehlern des Bedieners können größere Schäden entstehen. Weiter ist die Sicht des Bedieners, der die Bewegung des Roboters optisch überwacht, vielfach eingeschränkt. Dies gilt insbesondere in Vakuum-Kammern.

Weiterhin ist der Vorgang des Teach-In, oder der vorzugsweise regelmäßig durchgeführten Kontrolle des korrekten Teach-In zumeist damit verbunden, dass die Anlage geöffnet werden muss, wodurch sie außer Betrieb genommen werden muss, was entsprechende Ausfallzeiten erzeugt. Es muss dazu das sogenannte Minienvironment der Anlage geöffnet werden muss, wodurch die Anlage verunreinigt wird, was wiederum zusätzliche Ausfallzeiten der Maschine verursacht, um danach die erforderliche Sauberkeit in der Anlage wiederherzustellen.

Ein ungenaues Teach-In führt kann zu erhöhter Partikelgenerierung führen und damit zu verringerter Ausbeute des Prozesses, in welchem die Anlage verwendet wird. Ungenaues Teach-In kann ebenfalls zu Fehlern durch zu große Fehlablagen des Substrats, insbesondere Wafer, Maske, und/oder Flat-Panel-Display-Substrats führen.

### Aufgabe der Erfindung

Der Erfindung liegt demgegenüber die Aufgabe zugrunde, das Anlernen oder Kontrollieren eines Roboters zum Bewegen eines Wafers oder einer Maske oder eines Flat-Panel Displays zu vereinfachen.

### Zusammenfassung der Erfindung

Die Aufgabe der Erfindung wird bereits durch ein Verfahren zum Anlernen und/oder Kontrollieren eines Roboters sowie durch ein zur Ausführung des Verfahrens ausgebildetes System nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft ein Verfahren zum Anlernen und/oder Kontrollieren eines Roboters zum Bewegen eines Substrats eines Wafers oder eines Flat-Panel-Displays, also eines Substrats für einen Flachbildschirm, oder einer Maske, also einer fotolithographischen Maske.

Vorzugsweise erfolgt das erfindungsgemäße Verfahren mittels Erkennung des Wafers, der Maske, oder des Flat-Panel-Displays, und/oder der Erkennung der Auflage des Wafers, der Maske oder des Flat-Panel-Displays, und/oder der Erkennung von Markierungen in Anlagen der Prozessierung von Wafern, Masken oder Flat-Panel-Displays durch mindestens eine Kamera.

Das Verfahren beinhaltet insbesondere den Teach-in-Vorgang und/oder die Kontrolle einer Zielposition eines Roboters zur Prozessierung von Halbleiterbauelementen.

Gemäß der Erfindung wird zumindest eine Kamera verwendet, die die Bewegung des Roboters und/oder des Wafers oder der Maske für die Belichtung des Wafers und/oder eines Flat-panel-Displays aufnimmt.

Der Erfindung liegt also das Grundprinzip zugrunde, dass statt einer visuellen Kontrolle der Bewegungskurve eine Kamera verwendet wird, um den Roboter anzulernen oder zu kontrollieren.

Weiter liegt einer Ausführungsform der Erfindung die Kontrolle der Zielposition des vom Roboter bewegten Substrats zugrunde.

Unter der Bewegungskurve wird insbesondere die Bewegungskurve eines Arms eines Roboters, insbesondere eines Endeffektors und insbesondere bezüglich der Radial- und Theta-Bewegungen, verstanden. Weiter kann auch der Endeffektor selbst in die Bewegungstrajektorie eingebunden sein, indem dieser eigene Stellelemente, z.B. Piezos, zum Ausrichten des Substrats aufweist.

Über die Kamera kann insbesondere das Einhalten der Zielposition während des Teach-In kontrolliert werden.

Weiter kann über die Kamera das Einhalten der Zielposition auch während des Betriebs der Anlage fortlaufend kontrolliert werden.

So ist gemäß einer Ausführungsform der Erfindung vorgesehen, mittels einer Bilderkennungssoftware das Einhalten der Zielposition fortlaufend zu überwachen und bei einer Abweichung von einer Sollposition das Teach-In der Bewegungskurve automatisch nachzujustieren.

Eine Nachjustierung des Teach-In kann insbesondere auch bei Überschreitung zumindest eines Grenzwerts einer Ist- von einer Sollposition (insbesondere der Lage des Substrats), und/oder gesteuert durch ein übergeordnetes Steuerungssystem und/oder manuell durch einen Bediener erfolgen.

Das Einhalten der Zielposition kann insbesondere anhand der Position des Wafers, der Maske oder des Flat-Panel-Displays gegenüber der Aufnahme bestimmt werden.

Denkbar ist dabei auch, dass die Aufnahme Markierungen umfasst, anhand welcher die Einhaltung der Zielposition besser, insbesondere automatisiert, kontrolliert werden kann. Markierungen können beispielsweise von außen erkennbare und damit von der zumindest einen Kamera optisch erfassbare Gegenstände oder Teile hiervon sein, zum Beispiel bestimmte Bauteile oder Bauteilgeometrien, aber auch Aufkleber.

Gegenüber von sogenannten Masterbildern, welche häufig zum Bildabgleich verwendet werden, bietet dies den großen Vorteil, dass nicht nur Stationen bedient werden können, von welchen entsprechende Master- oder Referenzbilder vorliegen, etwa eine Kassette zur Aufnahme eines Wafers, welche dann immer die hinterlegte Geometrie aufweisen muss, sondern grundsätzlich alle Stationen, sofern die vorbestimmten Markierungen, die Auflagen, der Wafer, die Maske und/oder das Flat-Panel-Display vorhanden sind. Typischerweise wird bei Masterbildern das reale, aufgenommene Bild über das Masterbild gelegt, und während des Teach-In der Roboter solange bewegt, bis die beiden Bilder exakt übereinanderliegen.

Bei der vorliegenden Erfindung hingegen wird die Referenz, also die relative Position des Endeffektors zur Zielposition, über eine vorher bekannte Position und/oder Ausrichtung der zumindest einen Kamera auf dem Endeffektor und bekannter Abmessungen oder Positionen von Bauteilen des Systems, etwa Auflagen oder Markierungen, oder von Wafer, Maske oder Flat-Panel-Display im Sichtfeld der Kamera erzeugt, welche etwa über eine Bildanalysesoftware oder visuell durch einen Bediener erkannt werden können.

Bei einer bevorzugten Ausführungsform der Erfindung wird die Kamera auch dazu verwendet, beim Vorgang des Teach-Ins die Position und/oder die Orientierung des Wafers, der Maske oder des Flat-Panel-Displays in Relation zur Aufnahme und/oder von Markierungen der Aufnahme zu überwachen und auf diese Weise bereits während des Vorgangs des Teach-Ins zu ermöglichen, dass die auf diese Weise geteachte Position einer Sollposition entspricht.

Die Kamera kann auch verwendet werden, um fortlaufend die aktuelle Position des Wafers, der Maske oder des Flat-Panel-Displays während der Bewegung des Roboters zu überwachen. So kann insbesondere das Teach-in ganz oder teilweise automatisch ausgeführt werden.

Insbesondere kann anhand der Zielposition eine Bewegungskurve berechnet und unter Kontrolle mittels der Kamera abgefahren werden.

Bei einer Ausführungsform der Erfindung kann die Kamera an einem Arm des Roboters, insbesondere an einem Endeffektor, angeordnet sein. Die Kamera kann auch im Arm, insbesondere im Endeffektor, integriert sein.

Über einen Endeffektor wird das Substrat, also der Wafer, die Maske oder das Flat-Panel-Substrat einer Bearbeitungsstation zugeführt. Insbesondere entnimmt der Endeffektor das Substrat einer Ablage. Der Endeffektor kann beispielsweise einen mechanischen Greifer umfassen. Aber auch beispielsweise elektrostatisch oder mittels Luftdruck das Substrat aufnehmende Endeffektoren können für die Erfindung verwendet werden.

Die Kamera ist vorzugsweise derart ausgerichtet, dass diese zumindest eine Kante oder zumindest teilweise einen Umriss des Wafers oder der Maske oder des Flat-Panel-Displays aufnimmt. Kommt es beispielsweise beim Ablegen oder Aufnehmen des Wafers mittels des Endeffektors zu einer abrupten Bewegungsänderung der Kante oder des Umrisses des Wafers, so kann darauf geschlossen werden, dass der Roboter beim Ablegen oder Aufnehmen des Wafers oder der Maske oder des Flat-Panel-Displays nicht optimal positioniert ist. Die Positionierung kann sowohl die Positionen in x-, y- und z-Richtung (translatorische Freiheitsgrade), als auch die Winkel in den drei rotatorischen Freiheitsgraden und damit die Orientierung betreffen.

Selbstverständlich kann auch die Relativposition der Kamera und damit diejenige des Endeffektors zu Markierungen und/oder Auflagen in allen translatorischen und/oder rotatorischen Freiheitsgraden ermittelt werden, abhängig von der Anzahl der Kameras bzw. der erzeugten Bilder aus verschiedenen Kamerapositionen.

Ebenso selbstverständlich kann auch die Relativposition von Auflagen oder Markierungen zu Wafern, Masken oder Flat-Panel-Displays in allen in x-, y- und z-Freiheitsgraden translatorisch und rotatorisch ermittelt werden, abhängig von der Anzahl der Kameras bzw. der erzeugten Bilder aus verschiedenen Kamerapositionen.

Weiterhin kann die Kamera so ausgerichtet sein, dass sowohl zumindest eine Kante oder ein Umriss oder ein anderer Referenzpunkt des Wafers, der Maske oder des Flat-Panel-Substrates, als auch die Aufnahme und/oder einer oder mehrerer Markierungen der Aufnahme aufgenommen werden. Auf diese Weise kann auch der Vorgang des Teach-Ins überwacht werden, so dass die auf diese Weise geteachte Position eine Sollposition entspricht.

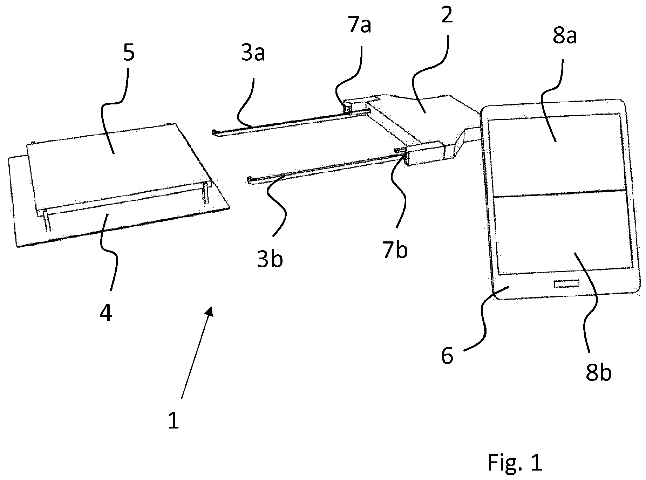

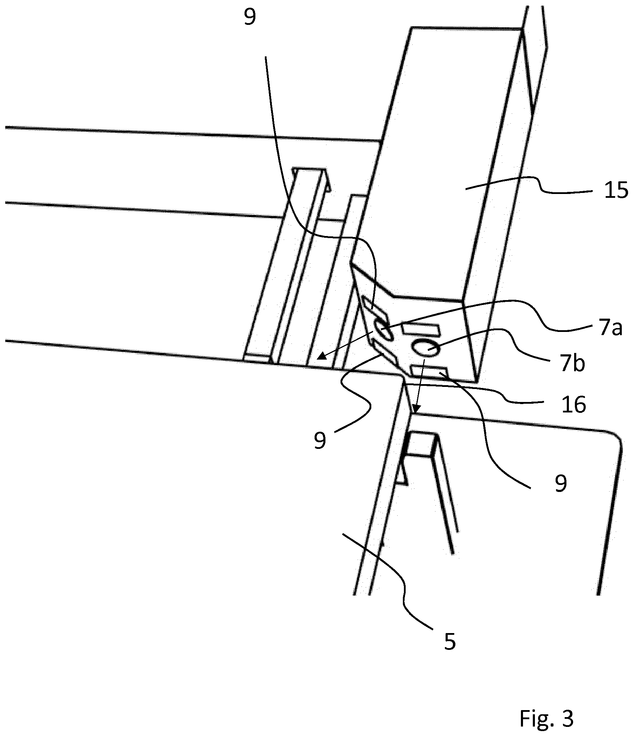

Weiterhin kann die Kamera so ausgerichtet sein, dass auch die Enden der Arme des Endeffektors im Sichtfeld der zumindest einen Kamera sind, und somit auch die Position Arme des Endeffektors, welche den Wafer, die Maske oder das Flat Panel Display aufnehmen, in Relation zum Wafer, oder der Maske, oder des Flat Panel Displays, oder der Aufnahme, oder der Markierungen bestimmt werden, beispielsweise visuell, oder durch eine Bildverarbeitung. Eine solche Ausrichtung einer Kamera ist beispielweise in einer Konfiguration nach Fig. 1 und Fig. 3, welche weiter unten beschrieben werden, ersichtlich, wo die Kamera 7b so ausgerichtet ist, dass zumindest das der Kamera gegenüberliegende Ende des Armes 3b im Sichtfeld der Kamera ist, zusammen mit der Maske 5 und der Auflage 4. Somit können in diesem Beispiel die Abstände zwischen dem Ende des Armes 3b, und/oder der Maske 5 und/oder der Auflage 4 bestimmt werden, entweder visuell oder mittels Bildverarbeitung.

Es versteht sich, dass aus denen mittels der Kamera beispielsweise in Anzahl von Kamera-Pixeln ermittelten Abständen zwischen Objekten des Systems, und Positionen von Objekten des Systems, unter Einbeziehung bekannter geometrischer Gegebenheiten eine Umrechnung in absolute Abstände und Positionen erfolgen kann, in den translatorischen und rotatorischen Freiheitsgeraden x, y und z. So kann beispielsweise der Abstand einer Kante einer Maske von einer Markierung absolut bestimmt werden, indem bekannte Abmessungen dieser Markierung von der Kamera in Anzahl von Kamera-Pixeln erfasst werden, und über trigonometrische Funktionen aus den bekannten absoluten Abmessungen der Markierung und deren Abbild in Pixeln der Kamera der in Pixeln der Kamera vorliegende Abstand der Markierung zu der Kante der Maske berechnet wird. Selbstverständlich können bei bekannter Pixelauflösung die Pixel auch direkt in absolute Abmessungen und Abstände umgerechnet werden.

Mit der Erfindung können auch absolute Abstände bestimmt werden zwischen dem Substrat, also dem Wafer, der Maske oder dem Flat-Panel-Display, und/oder von der Auflage, und/oder von Markierungen, und/oder der Position des Endeffektors, und/oder dem Greifer bzw. den Armen des Endeffektors, beispielsweise visuell oder durch eine Bildverarbeitung.

Die Verwendung der Kamera ermöglicht erstmals auch den Teach-in-Vorgang automatisiert oder zumindest teilweise automatisiert durchzuführen. So kann beispielsweise über eine automatische Bilderkennung und eine Regelschleife die Position des Endeffektors beim Ablegen oder Aufnehmen des Wafers oder der Maske oder des Flat-Panel-Displays derart angepasst werden, dass es nicht zu einem abrupten Sprung in der Bewegung der Kante kommt.

Weiterhin ist es durch Verwendung der Kamera möglich, die Kontrolle des korrekten Teach-Ins während des Betriebes der Anlage auszuführen, wodurch Ausfallzeiten vermieden werden. Die Kamera kann also auch einer Prozesskontrolle dienen.

Die Kamera kann, wie es bei einer weiteren Ausführungsform der Erfindung vorgesehen ist, auch das gesamte Substrat, also die Maske, den Wafer, oder das Flat-Panel-Substrat, derart erfassen, dass sich dieses vollständig im Erfassungsbereich der Kamera befindet.

Bei einer weiteren Ausführungsform der Erfindung werden durch die durch die Kamera aufgenommenen Daten, oder darauf basierend durch eine Bildverarbeitung bearbeiteten Daten und/oder weiterverarbeiten Daten, Reaktionen in der Anlage initiiert und/oder an ein der Anlage übergeordnetes Steuerungssystem gesendet, insbesondere um die Anlage durch das übergeordnete Steuersystem zu überwachen.

Weiterhin können die durch die Kamera aufgenommenen Daten, oder darauf basierend durch eine Bildverarbeitung bearbeiteten Daten, oder auch weiterverarbeiten Daten, wie beispielsweise die Einhaltung definierter Grenzwerte von Positionen, eine Tendenz der Veränderungen von Positionen oder Auftreten von Vibrationen ermittelt werden, und in der Anlage zur Auslösung von Reaktionen, wie beispielsweise ein neues Teach-In, verwendet werden, und/oder an ein der Anlage übergeordnetes Steuerungssystem gesendet werden, insbesondere um die Anlage durch ein übergeordnetes Steuersystem zu überwachen.

Weiterhin kann durch Verwendung der Kamera vermieden werden, das Mini-Environment der Anlage zu öffnen, wodurch zusätzliche Ausfallzeiten zur Wiederherstellung der Sauberkeit der Anlage vermieden werden.

Das von der Kamera aufgenommene Bild wird gemäß einer bevorzugten Ausführungsform der Erfindung auf ein Display, insbesondere auf ein Display eines tragbaren elektronischen Gerätes übertragen.

Das Bild kann so an beliebiger Position des Bedieners abgelesen werden. Insbesondere kann beispielsweise das Bild auch zusätzlich zu einer gleichzeitig durchgeführten visuellen Kontrolle verwendet werden.

Bei einer Weiterbildung der Erfindung werden mehrere, z.B. zwei, Kameras verwendet. Damit kann der Wafer, die Maske oder das Flat-Panel-Display bzw. dessen/deren Umriss zumindest teilweise, sowie und/oder die Aufnahme des Wafers, der Maske oder des Flat-Panel-Displays und/oder deren Markierungen aus mehreren Richtungen aufgenommen werden, was es ermöglicht, mehr Informationen über die Positionen oder Winkel zu erhalten, und auf diese Weise beispielsweise die Position in Relation zur Aufnahme in allen drei translatorischen und/oder rotatorischen Freiheitsgraden zu ermitteln.

Mit der zumindest einen Kamera wird insbesondere ein Versatz des Wafers oder der Maske oder des Flat-Panel-Displays gegenüber einer Sollposition gemessen.

Gemäß einer Ausführungsform der Erfindung wird die zumindest eine Kamera nur temporär angebracht, insbesondere unter Verwendung einer werkzeuglos anbringbaren Befestigung.

Bei dieser Ausführungsform der Erfindung ist also vorgesehen, dass ein Set mit einer Kamera bereitgestellt wird, welches temporär für den Teach-in-Vorgang verwendet und im Anschluss wieder abgebaut wird.

Gemäß einer anderen Ausführungsform der Erfindung ist es vorgesehen, dass die Kamera stationär in der Anlage verbleibt. Dies bedeutet, dass sich die Kamera permanent in dem Arbeitsraum und/oder an dem Roboter bzw. dem Endeffektor befindet.

So kann die Kamera auch fortlaufend verwendet werden, beispielsweise, um den Roboter während des regulären Betriebs zu kontrollieren, oder das Teach-In ohne Öffnen des Mini-Environments der Anlage vorzunehmen.

Die Kamera kann insbesondere in einer Vakuumkammer installiert sein.

Bei einer Weiterbildung der Erfindung wird ein Kamera-Modul mit einer integrierten Beleuchtung verwendet.

Eine weitere Ausführungsform verwendet eine Infrarotkamera.

Die Infrarotkamera wird gemäß einer Ausführungsform der Erfindung verwendet, um im Bewegungsbereich des Roboters und sich daraus ergebenden Sichtbereich der Kamera Messpunkte, zum Beispiel sich dort befindliche, auf die an dieser Stelle herrschende Temperatur temperierte Gegenstände anzufahren und deren Temperatur zu messen, oder um beispielsweise auch die Temperaturverteilung im Raum zu messen.

Die Infrarotkamera kann zur Messung der Temperatur der Maske, des Wafers oder des Flat-Panel-Displays, oder von Gegenständen in der Anlage zur Prozessierung von Halbleiterbauelementen verwendet werden.

Gemäß einer Ausführungsform wird die Infrarotkamera zusätzlich zu einer bildgebenden Kamera für den sichtbaren Wellenlängenbereich verwendet werden.

Das Bild der Kamera wird gemäß einer Ausführungsform der Erfindung drahtlos übertragen, insbesondere an ein tragbares elektronisches Gerät, wie beispielsweise ein Tablet.

Eine drahtlose Übertragung ist insbesondere bei der Ausführungsform des Verfahrens, bei welchem die Kamera nur temporär installiert wird, sinnvoll. Vorzugsweise wird dann auch eine Kamera mit integriertem Akku verwendet.

Bei dauerhaft eingesetzter Kamera erfolgt Bildübertragung und/oder Stromversorgung der Kamera vorzugsweise über Kabel.

Gemäß einem weiteren Aspekt der Erfindung wird zumindest eine Kamera in einem Verfahren zur Prozessierung von Halbleiterbauelementen verwendet. Insbesondere betrifft dieser Aspekt der Erfindung das vorstehend beschriebene Verfahren.

Gemäß der Erfindung wird mittels der zumindest einen Kamera überprüft, ob ein Wafer, eine Maske oder Flat-Panel-Display auf einer Aufnahme und/oder einem Endeffektor vorhanden ist.

Insbesondere erfolgt diese Überprüfung, ohne mit weiteren Sensoren zusammenzuwirken. Dies verringert den anlagentechnischen Aufwand. Es ist möglich, den Roboter teilweise oder als Ganzes in einem Reinraum einzusetzen. Vorzugsweise ist daher die zumindest eine Kamera und/oder der Roboter reinraumtauglich ausgebildet für eine Verwendung in Reinräumen der Klasse ISO 6 oder besser, bevorzugt Klasse ISO 5 oder besser und besonders bevorzugt Klasse ISO 4 oder besser, gemäß ISO 14644-1 und ISO 14644-2.

In Anlagen zur Prozessierung von Wafern, Masken oder Flat-Panel-Displays ist es ansonsten üblich, dass durch Sensoren, beispielsweise am Endeffektor oder an der Waferauflage, überprüft wird, ob sich mindestens ein Wafer, eine Maske oder ein Flat-Panel-Display auf einer Aufnahme oder auf dem Endeffektor selber befindet oder nicht. Auf derartige Sensoren kann durch die Verwendung der Kamera, insbesondere der Kamera am Endeffektor, verzichtet werden.

Gemäß einer Ausführungsform der Erfindung wird mittels der zumindest einen Kamera die Belegung eines Behälters, insbesondere einer Kassette, oder einer Auflage, mit Substraten eines Wafers, einer Maske oder eines Flat-Panel-Displays ermittelt.

Die zumindest eine Kamera kann auch eingesetzt werden, um anstelle oder in Ergänzung zu anderen Sensoren zu arbeiten, und die oben genannten Funktionen erfüllen. Dazu kann die zumindest eine vorstehend beschriebene Kamera und/oder zusätzliche Kameras zur Kontrolle des Roboters verwendet werden. Zumindest eine zusätzliche Kamera kann auch allein zur o.g. Kontrolle des Wafers, der Maske oder des Flat-Panel-Displays verwendet werden, ohne gleichzeitig den Roboter zu kontrollieren.

Die Kameras können somit zwei Funktionen erfüllen: Kontrolle des Roboters und/oder eine Überprüfung der Masken, Wafer oder Flat-Panel-Displays.

Auf weitere Sensoren, die beispielsweise an einer Kassette oder anderen Aufnahmen zu scannen, in denen sich mehrere Wafer, Masken oder Flat-Panel-Displays befinden können, detektieren, in wie weit eine Belegung vorliegt, kann ggf. verzichtet werden.

Mittels der zumindest einen Kamera kann also z.B. eine Belegung einer Kassette ermittelt werden.

Weiter kann mittels der zumindest einen Kamera überprüft werden, auf welcher Seite oder in welcher Orientierung sich eine Fotomaske (sog. Pellicle) einer Maske befindet.

Es kann insbesondere überprüft werden, in welcher Lage oder Orientierung sich diese Wafer, Masken oder Flat-Panel - Substrate befinden, ob sie sich beispielsweise nicht innerhalb eines Toleranzbereiches in der vorgesehenen Aufnahmeposition befinden, ob sie beispielsweise schräg stehen (beispielsweise in einer Kassette, wo sich mehrere Wafer, Masken oder Flat-Panel-Displays nebeneinander oder übereinander befinden können), oder auch ob beispielsweise mindestens zwei Wafer, Masken oder Flat-Panel-Displays direkt aufeinander liegen, oder beispielweise schräg über mehrere Etagen einer Kassette.

Am Beispiel eines erfindungsgemäßen Roboters zum Bewegen einer Maske soll ein bevorzugter Ablauf des erfindungsgemäßen Verfahrens zum Anlernen und/oder Kontrollieren des Roboters dargestellt werden. Es ist selbstverständlich, dass dieser Ablauf mit oder ohne Modifikationen auch für das Bewegen anderer Substrate, etwa eines Flat-Panel-Displays oder eines Wafers, verwendet werden kann.

Im Beispiel soll eine Bewegungskurve bereits ermittelt und in einem hierzu geeigneten Speicher hinterlegt sein. Der Speicher kann direkt in den Roboter integriert sein oder auch in einem externen Gerät, etwa einem externen Steuergerät, angeordnet sein. Anhand dieser Bewegungskurve wird der Endeffektor mit der zumindest einen Kamera von einer Ausgangsposition bewegt zu einer Aufnahmeposition, bei welcher die Aufnahme der Maske durch den Endeffektor bzw. einen Greifer erfolgen soll.

Vor Erreichen dieser Aufnahmeposition wird die Kamera computergesteuert eingeschaltet. Sofern eine integrierte Beleuchtung vorhanden ist, kann diese ebenfalls eingeschaltet werden. Vorzugsweise kann nunmehr, sobald oder sofern sich die Maske im Sichtfeld der Kamera befindet oder befinden sollte, zumindest ein Bild mit der Kamera aufgenommen und an eine Auswerteeinheit, welche eine geeignete Bilderkennungssoftware umfassen kann, übertragen werden. Anstelle einer automatischen Bildanalyse oder ergänzend hierzu kann auch eine visuelle Auswertung durch einen Bediener erfolgen. Hierzu kann das zumindest eine Bild der Kamera an ein Display übertragen werden, beispielsweise an das Display eines tragbaren elektronischen Gerätes wie ein Tablet, vorzugsweise drahtlos.

Es kann sich eine automatische Bildanalyse anschließen, bei der geprüft wird, ob überhaupt eine Maske an der vorgesehenen Position vorhanden ist. Ist keine Maske vorhanden, kann gemäß einer Ausführungsform der Erfindung der Endeffektor wieder zurück auf die Ausgangsposition bewegt und die Kamera kann ausgeschaltet werden.

In einer Ausführungsform der Erfindung kann anhand des Kamerabildes überprüft werden, ob eine Maske ein Pellicle hat, in welcher Position sich das Pellicle befindet (oben oder unten), und/oder in welcher Orientierung um die vertikale Achse sich dieses Pellicle befindet (bezogen auf eine flach liegende Maske).

Es kann hilfreich sein, wenn vor Erreichen der Aufnahmeposition mehr als ein Bild aufgenommen wird, um Bilder von der Maske unter unterschiedlichen Blickwinkeln und/oder bei unterschiedlicher Beleuchtung zu machen. Vorzugsweise werden eine Vielzahl von Bildern aufgenommen und fortlaufend analysiert, von Vorteil vor und während der Aufnahme der Maske, um die Positionierung und/oder die Orientierung der Maske relativ zum Endeffektor vorzugsweise kontinuierlich oder nahezu kontinuierlich zu überwachen. Dies ermöglicht auch das Messen von Abständen.

Eine Bildaufnahme unter verschiedenen Blickwinkeln ermöglicht es, den Wafer, die Maske oder das Flat-Panel-Display bzw. die entsprechende Umrisse zumindest teilweise, und/oder die Aufnahme des Wafers, der Maske oder des Flat-Panel-Displays und/oder von Markierungen aus mehreren Richtungen aufzunehmen. Hierdurch ist es möglich, mehr Informationen über die Positionen oder Winkel zu erhalten, und auf diese Weise die Position und/oder die Orientierung in Relation zur Aufnahme in allen drei translatorischen und/oder rotatorischen Freiheitsgraden zu ermitteln. Dies ermöglicht es in einer nochmaligen Weiterbildung der Erfindung, mit nur einer einzigen Kamera auszukommen und damit auf den Einsatz mehrerer Kameras zu verzichten.

Eine Ausführungsform der Erfindung ermöglicht es, Abstände in Richtung der optischen Achse der Kamera zu messen, beispielsweise während der Annäherung den Abstand zwischen Endeffektor und Maske. Diese Information kann dann wiederum zur Steuerung der Geschwindigkeit des Roboters bzw. des Endeffektors verwendet werden, wobei dann zum Beispiel von einer hohen Geschwindigkeit zu einer geringen Geschwindigkeit gewechselt werden kann, wenn die Aufnahme der Maske unmittelbar bevorsteht. Dies ermöglicht einen sehr effizienten Betrieb.

Weiterhin können die relativen Positionen des Endeffektors, von Auflagen oder Markierungen, oder von Wafern, Masken oder Flat-Panel-Displays zueinander durch zumindest eine Kamera visuell oder automatisch durch eine Bildverarbeitung bestimmt werden.

Hierdurch können zudem Ablagefehler beim Bewegen, Aufnehmen oder Ablegen von Wafern, Masken oder Flat-Panel-Displays, welche sich beispielsweise durch Dejustierung des Systems während des Betriebes, Verschleiß, oder Alterungserscheinungen ergeben können, erkannt und kompensiert werden.

Weiterhin können Beschädigungen an der Auflage, an den Markierungen oder an den Armen des Endeffektors festgestellt werden, beispielsweise, wenn diese nicht mehr in einer erwarteten Position sind, beispielsweise infolge eines vorangegangenen Fehlers im System.

Nach der Aufnahme der Maske kann der Endeffektor zu einer Abgabeposition bewegt werden, an der der Wafer abgelegt werden soll. Hier kann der Wafer entsprechend abgelegt werden, wobei ebenfalls die zumindest eine Kamera wie vorstehend erläutert unterstützend eingesetzt werden kann. Nach Ablegen der Maske kann der Endeffektor wieder auf die Ausgangsposition zurückgeführt werden.

Durch die kontinuierliche oder nahezu kontinuierliche Überwachung während der Aufnahme und/oder während des Ablegens ist es möglich, das Verfahren ohne Hinterlegung eines Referenzbildes zum Abgleichen zu betreiben.

Das erfindungsgemäße Verfahren zum Anlernen und/oder Kontrollieren eines Roboters zum Bewegen eines Wafers oder einer Maske, oder eines Flat-Panel-Displays ermöglicht einen vollautomatischen Teach-in-Vorgang als auch eine automatische Prozessüberwachung des Roboters im regulären Betrieb.

Dabei ist es auch möglich, die Orientierung und die Position des aufzunehmenden Substrates relativ zum Endeffektor unmittelbar vor und/oder während der Aufnahme durch den Endeffektor zu überwachen, was gerade in Bezug auf zerbrechliche Substrate wie etwa Wafer, Masken, oder Flat-Panel-Display von großer Bedeutung ist, da hier bereits ein leicht von einer Idealposition abweichender Auftreffwinkel von Greifern auf das Substrat zur Zerstörung führen kann.

Das erfindungsgemäße Verfahren ermöglicht ferner einen Betrieb auch unter Reinraumbedingungen. Hierbei ist von großen Vorteil, dass der Reinraum-Arbeitsbereich bzw. das Reinraum-Mini-Environment weder beim Teach-in-Vorgang noch bei der Prozessüberwachung oder Überprüfung des Handlingsystems geöffnet werden muss. Dies führt zu einem deutlich effizienteren Betrieb.

Das erfindungsgemäße Verfahren ermöglicht schließlich ein sogenanntes "Mapping", also die Erkennung von Substraten wie Wafer, Maske oder Flat-Panel-Display in Kassetten oder auf Auflagen, die Erkennung von Fehllagen von Substraten, die Erkennung von beispielsweise Pelliclen und deren Lage auf Masken.

Die Erfindung betrifft des Weiteren ein System, welches zur Ausführung des vorstehend beschriebenen Verfahrens ausgebildet ist.

Das System umfasst insbesondere eine Anlage zur Prozessierung von Halbleiterbauelementen.

Vorzugsweise umfasst das System eine Kamera, die auf einen Auflagepunkt eines Wafers oder Maskensubstrats oder eines Flat Panel Displays gerichtet ist.

So kann mittels der Kamera beobachtet werden, ob es beim Ablegen oder Aufnehmen des Wafers oder der Maske oder des Flat Panel Displays zu einem Versatz kommt, der auf eine Fehlpositionierung des Endeffektors hindeutet.

Die Kamera ist gemäß einer bevorzugten Ausführungsform der Erfindung am Endeffektor angeordnet, insbesondere in den Endeffektor integriert.

Erfindungsgemäß werden vorzugsweise sehr kleine Kameras eingesetzt, beispielsweise mit einem Durchmesser von 5 mm oder weniger, bevorzugt 4 mm oder weniger, besonders bevorzugt 3 mm oder weniger, welche zudem von Vorteil durch ein geringes Gewicht auszeichnen. Auf diese Weise kann verhindert werden, dass es im Bereich des Endeffektors zu einer unerwünschten Verbiegung durch das Gewicht der Kamera selbst kommt.

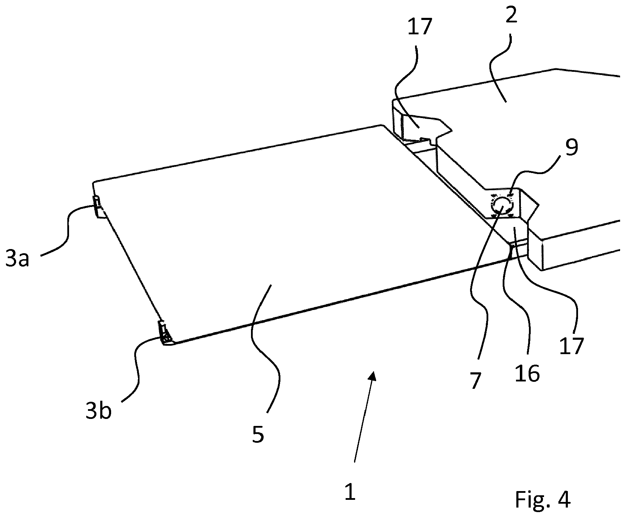

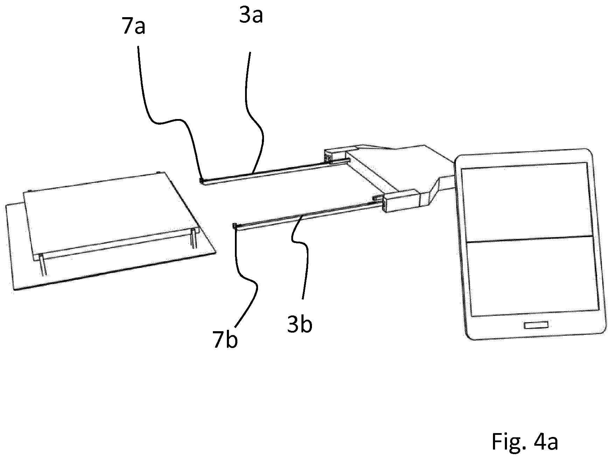

Weiterhin können sehr kleine Kameras auch in kleinen Zwischenräumen, beispielsweise zwischen mehreren übereinanderliegenden Wafern, Kassetten oder Flat Panel Displays eingesetzt werden, was eine Ausführungsform entsprechend der weiter unten beschriebenen Fig. 4a ermöglicht, wo die Kameras 7a und 7b, welche auch eine Beleuchtung beinhalten können, am Ende der Arme beziehungsweise Gabeln 3a und 3b angebracht sind.

Gemäß einer weiteren Ausführungsform der Erfindung befindet sich eine Kamera an oder in der Nähe der Aufnahme des Wafer- oder Maskensubstrats oder eines Flat-Panel-Displays und/oder im Chuck.

### Kurzbeschreibung der Zeichnungen

Der Gegenstand der Erfindung soll im Folgenden bezugnehmend auf schematisch dargestellte Ausführungsbeispiele anhand der Zeichnungen Fig. 1 bis Fig. 6 näher erläutert werden.
Fig. 1 zeigt ein erstes Ausführungsbeispiel, bei welchem eine Kamera am Endeffektor angebracht ist.
Fig. 2 zeigt ein Ausführungsbeispiel, bei welchem eine Kamera an einer Aufnahme für einen Wafer oder eine Maske angeordnet ist.
Fig. 3 zeigt ein Ausführungsbeispiel, bei welchem zwei Kameras unmittelbar aneinander angrenzen und die Kanten eines Wafers oder einer Maske aufnehmen.
Fig. 4 zeigt ein Ausführungsbeispiel eines Endeffektors mit integrierter Kamera.
Fig. 4a zeigt ein Ausführungsbeispiel eines Endeffektors mit Kameras in den Armen.
Fig. 5 zeigt eine Anlage zur Prozessierung von Halbleiterbauelementen, bei welcher ein erfindungsgemäßer Endeffektor mit integrierter Kamera verwendet wird.
   Fig. 5a-5c zeigen die Anlage in verschiedenen Betriebszuständen.
Fig. 6 ist ein Flussdiagramm der Verfahrensschritte eines Ausführungsbeispiels des erfindungsgemäßen Verfahrens.

### Detaillierte Beschreibung der Zeichnungen

Fig. 1 zeigt in einer schematischen Ansicht ein System 1 zur Prozessierung von Halbeiterbauelementen.

Das System 1 umfasst einen Endeffektor 2 mit den Armen 3a, 3b, über die eine Maske 5 oder ein Wafer auf einer Ablage 4 abgesetzt und/oder aufgenommen werden kann.

Der Endeffektor ist Teil eines Roboters (nicht dargestellt) und wird über den Roboter in mehreren Raumrichtungen bewegt. Insbesondere kann ein Roboter mit einer Radial- und Theta-Achse verwendet werden.

Gemäß der Erfindung umfasst das System zumindest eine Kamera 7a, 7b, welche in diesem Ausführungsbeispiel mitbewegend am Endeffektor 2 angeordnet ist.

In diesem Ausführungsbeispiel sind zwei Kameras 7a, 7b vorgesehen.

Die Kameras 7a, 7b befinden sich in diesem Ausführungsbeispiel vorne am Endeffektor 2 zwischen oder neben den Armen 3a, 3b.

Das Bild der Kameras 7a, 7b wird an ein elektronisches Gerät, in diesem Ausführungsbeispiel an ein tragbares Tablet 6, übertragen.

In diesem Ausführungsbeispiel sind auf dem Tablet die Ansichten der Kameras 7a, 7b getrennt als Ansicht 8a und Ansicht 8b dargestellt. Die kann beispielsweise über einen geteilten Bildschirm realisiert sein.

Beispielsweise ist möglich, dass die Kamera 7a auf den Arm 3a gerichtet ist, wohingegen die Kamera 7b auf die vordere Kante der Maske 5 bzw. des Wafers gerichtet ist.

So kann zum einen über die Kamera 7a der Bewegungsverlauf des Endeffektors 2 kontrolliert werden.

Über die Kamera 7b kann auf einfache Weise festgestellt werden, wenn es zu einem Versatz beim Aufnehmen oder Ablegen der Maske 5 bzw. des Wafers kommt, oder ob sich die Maske bzw. der Wafer in der richtigen Position befindet.

Weiter kann über die Kameras 7a, 7b überprüft werden, ob sich eine Maske 5 bzw. ein Wafer auf dem Endeffektor 2 befindet. Auf weitere Sensoren, die ein Vorhandensein der Maske 5 bzw. des Endeffektors 2 detektieren, kann so verzichtet werden.

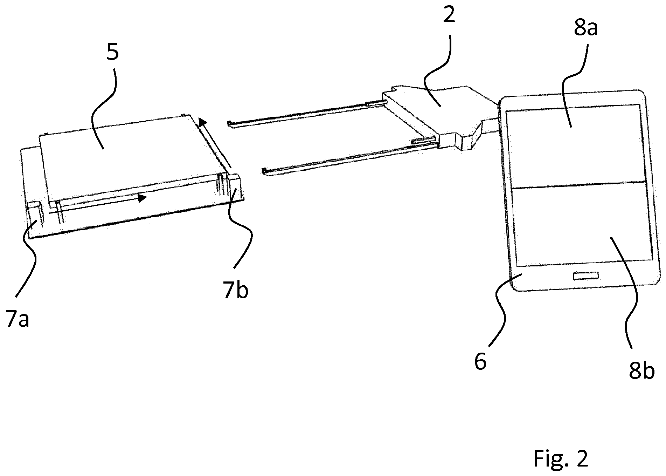

Fig. 2 zeigt schematisch ein alternatives Ausführungsbeispiel der Erfindung, bei welcher die zumindest eine Kamera nicht mitbewegend angeordnet ist.

In diesem Ausführungsbeispiel sind zwei Kameras 7a, 7b vorgesehen, welche jeweils entlang einer anderen Kante der Maske 5 bzw. des Wafers ausgerichtet sind. Die Blickrichtung der Kameras ist jeweils mit einem Pfeil gekennzeichnet.

Über die beiden Kameras 7a, 7b, deren Bild entsprechend der Ansichten 8a und 8b auf das Tablet 6 übertragen wird, kann auf einfache Weise erkannt werden, wenn es beim Aufnehmen oder Ablegen zum Versatz in eine Richtung kommt und/oder wenn die Zielposition von einer Sollposition abweicht.

Sofern es zu einem Versatz kommt, kann der Bediener beim Teach-in-Vorgang den Bewegungsablauf des Endeffektors 2 derart ändern, dass ein Versatz weitgehend vermieden wird.

Sowohl bei dem Ausführungsbeispiel gemäß Fig. 1 als auch bei dem Ausführungsbeispiel gemäß Fig. 2 kann die Kamera eine integrierte Beleuchtung aufweisen.

Fig. 3 zeigt ein Ausführungsbeispiel, bei welchem in einem einzigen Kameragehäuse 15 zwei Kameras an einer Ecke der Maske 5 bzw. des Wafers angeordnet sind.

Die Blickrichtungen der Kameras 7a, 7b sind mit einem Pfeil gekennzeichnet.

Zu erkennen ist, dass jede der Kameras 7a, 7b die von der Ecke 16 ausgehende Kante aufnimmt. Von Vorteil sind die beiden Kameras 7a, 7b derart angeordnet, dass ihre Blickrichtungen bzw. ihre optischen Achsen nicht parallel zueinander stehen, sondern einen Winkel zueinander bilden. Dieser Winkel kann unterschiedlich ausgeführt sein und liegt von Vorteil zwischen 5° und 90°, im Beispiel bei etwa 20° bis 30°. Diese Bauweise ermöglicht einen besonders kompakten Aufbau des Kameragehäuses 15 und damit eine einfache Montage an dem Endeffektor.

So kann ebenfalls auf einfache Weise ein Versatz beim Aufnehmen oder Ablegen festgestellt werden.

Vorzugsweise ist das Kameragehäuse 15 am Endeffektor angebracht.

Das Kameragehäuse 15 kann des Weiteren jeweils eine Beleuchtung 9 (z.B. LEDs) für das Sichtfeld der Kameras 7a, 7b umfassen. Die Beleuchtung 9 ist dabei vorzugsweise derart angeordnet, dass die Haupt-Abstrahlrichtung des Lichtes parallel zu der Blickrichtung der Kameras 7a, 7b verläuft.

Fig. 4 zeigt ein Ausführungsbeispiel, bei welchem eine Kamera 7 mit integrierter Beleuchtung 9 im Endeffektor 2 integriert ist.

Hierzu umfasst der Träger des Endeffektors 2, aus welchem die Arme 3a, 3b hervorstehen, eine Einbuchtung 17, innerhalb der die Kamera 7 angeordnet ist. Die Kamera 7 ist bei dieser Ausführungsform der Erfindung schräg in das Gehäuse des Endeffektors 2 eingebaut.

So nimmt die Kamera 7, welche ein stabförmiges Gehäuse (nicht dargestellt) aufweisen kann, größtenteils ansonsten ungenutzten Raum im Gehäuse des Endeffektors 2 ein. Weiter kann durch die schräge Anordnung ein großes Sichtfeld bereitgestellt werden. Die optische Achse der Kamera 7 kann insbesondere einen Winkel von 30 bis 60° zur Haupterstreckungsrichtung der Arme 3a, 3b einnehmen.

Die zumindest eine Kamera 7 befindet sich in der Einbuchtung 17 in einer schräg verlaufenden Fläche, so dass die Kamera auf die Ecke 16 der Maske 5 bzw. des Wafers gerichtet ist.

Es versteht sich, dass in der zweiten Einbuchtung 17 vorzugsweise ebenfalls eine Kamera vorhanden ist oder sein kann, welche in dieser Ansicht verdeckt ist.

Fig. 4a zeigt eine weitere Ausführungsform der Erfindung, bei welcher die Kameras 7a und 7b an den Armen 3a, 3b des Endeffektors 2 angeordnet sind.

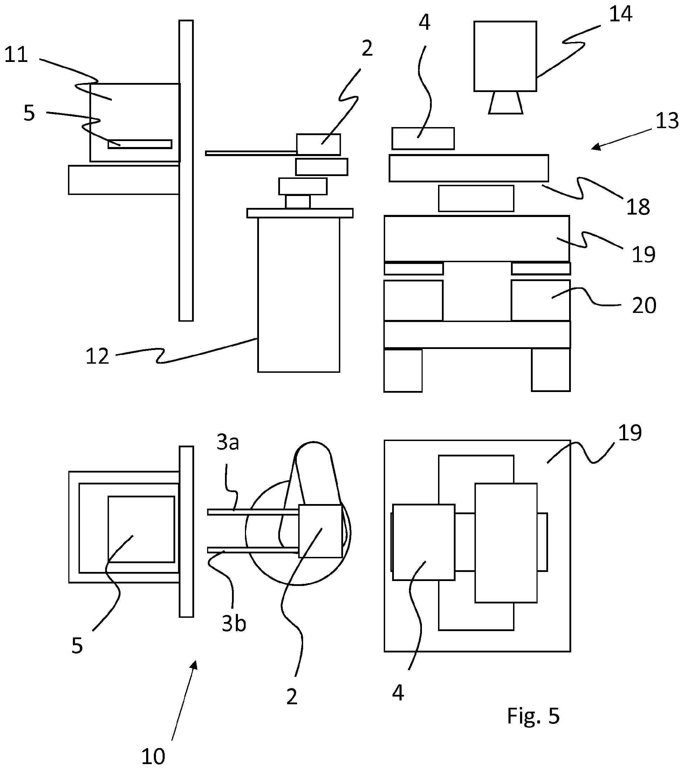

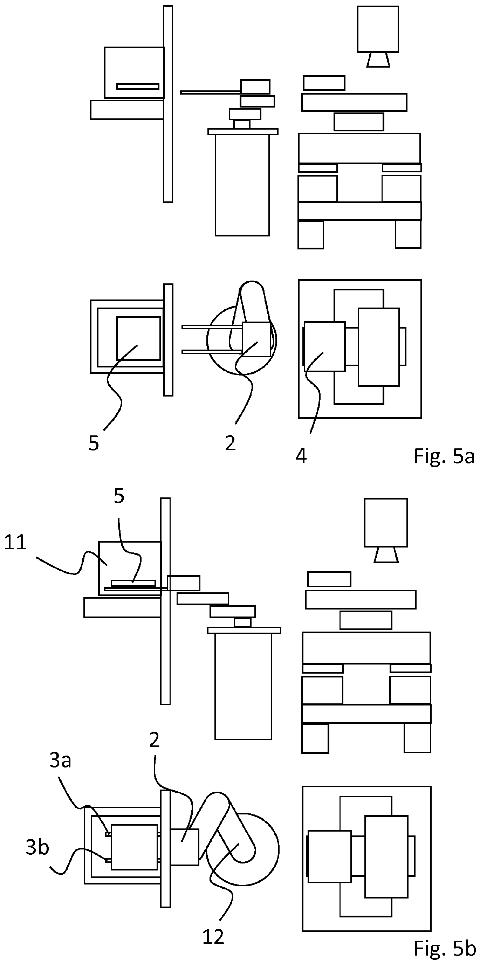

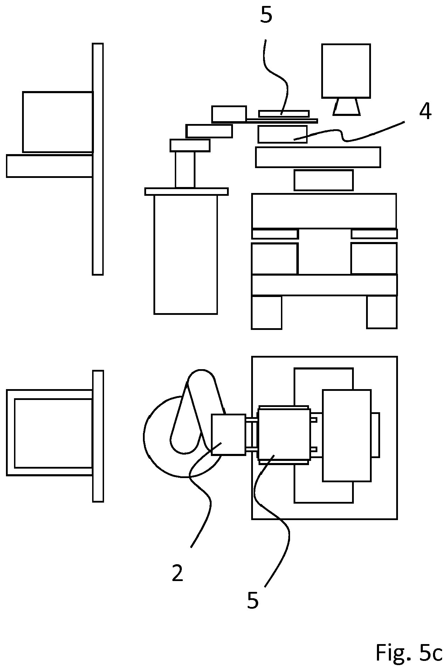

Fig. 5 zeigt in einer Seitenansicht und einer darunter dargestellten Draufsicht von oben wesentliche Bestandteile einer Anlage 10 zur Prozessierung von Halbleiterbauelementen.

Die Anlage 10 zur Prozessierung von Halbleiterbauelementen umfasst einen Behälter für Wafer oder im abgebildeten Fall für Masken 11, welcher im abgebildeten Fall insbesondere als FOUP (front opening unified pod) abgebildet ist, welcher mit einem SMIF (standard mechanical interface) Loadport geöffnet oder geschlossen wird.

In diesem Behälter 11 befinden sich die Substrate der zu prozessierenden Wafer 5 auf einer (nicht dargestellten) Aufnahme.

Mittels eines Roboters 12 mit dem Endeffektor 2 können dem Behälter 11 Substrate entnommen und an die Bearbeitungsstation 13 weitertransportiert werden.

Die Bearbeitungsstation 13 umfasst in diesem Ausführungsbeispiel eine verfahrbare Bühne 18 (Stage), auf welcher sich als Aufnahme für die Maske 5 ein Chuck befindet.

Die hier darstelle Maschine zur Prozessierung von Masken 5 kann insbesondere ein Inspektionsgerät 14 umfassen, welches sich auf einer Platte 19 befindet, die schwingungsisoliert von den Isolatoren 20 abgestützt wird.

Zumindest der Endeffektor 2 des Roboters 12 umfasst eine Kamera, mittels der der Roboter 12 auf einfache Weise angelernt und/oder kontrolliert werden kann.

Mittel der Kamera am Endeffektor 2 kann gleichzeitig die Belegung des Behälters 11 mit Substraten geprüft werden. Der Roboter 12 fährt so nur Aufnahmen an, in denen sich auch ein Substrat befindet.

Fig. 5a zeigt die in Fig. 5 dargestellte Anlage im Ruhezustand. Wie in Fig. 5a dargestellt, wird zur Aufnahme der Maske 5 aus dem Behälter 11, der Endeffektor mit seinen Armen 3a, 3b unter die Maske 5 gefahren.

Die Maske 5 wird mit dem Roboter 2 angehoben und in die Fig. 5c dargestellte Zielposition auf der Ablage 4 verfahren. Die Zielposition wird von der der am Endeffektor angeordneten Kamera kontrolliert.

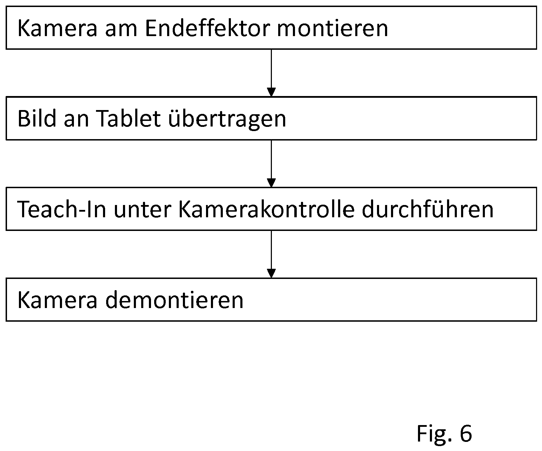

Fig. 6 zeigt schematisch wesentliche Schritte eines erfindungsgemäßen Verfahrens.

Zunächst wird eine Kamera an einem Endeffektor montiert. In einer anderen Ausführungsform ist die Kamera ständig am Endeffektor montiert.

Mittels der Kamera wird ein Bild während eines Teach-in-Vorgang an ein Tablet übertragen und der Teach-in-Vorgang wird unter Kamerakontrolle durchgeführt.

Im Anschluss wird die Kamera demontiert, nachdem das Teach-in fertiggestellt ist, sofern die Kamera nicht ständig am Endeffektor montiert ist.

Über die Verwendung einer Kamera kann eine Genauigkeit des Teach-In-Verfahrens von weniger als 50 µm erreicht werden, was gegenüber einer rein visuellen Kontrolle eine höhere Genauigkeit nach sich zieht.

Weiter kann das Kamerabild aufgenommen werden und so beispielsweise in Zeitlupe abgespielt werden, um den Teach-in-Vorgang zu optimieren.

Das Teach-in wird durch kontinuierliche Sicht auf die Ablagestation vereinfacht.

Weiter kann der Teach-in-Vorgang in der Regel durch eine einzige Person durchgeführt werden und es wird das Risiko von Beschädigungen während des Teach-ins reduziert.

Insbesondere ist auch ein Teach-in-Vorgang in einer geschlossenen Anlage, wie beispielsweise einer Vakuumkammer, auf einfachere Weise möglich. Die Verkleidung der Halbleiteranlage braucht bei Verwendung der Kamera nicht geöffnet zu werden.

Beispielsweise über Clips kann die Kamera werkzeuglos installiert werden.

Weiter kann mittels automatisierter Bildverarbeitung auch eine Positions- und Lageerkennung bereitgestellt werden.

Über geschlossene Regelkreise unter Verwendung der Positionserkennung einer mit der Kamera verbundenen Bilderkennungs-Software kann eine genauere Steuerung des Endeffektors erreicht werden. Beispielsweise kann für die Erfindung ein Endeffektor verwendet werden, bei welchem die Positionierung der Masken/Wafer oder Flat-Panel-Displays auf die Aufnahme durch im Endeffektor integrierte Motoren, beispielsweise mittels eines Piezos, erfolgt. So ist eine genauere Positionierung der Maske bzw. des Wafers oder Flat-Panel-Displays möglich, als über den entfernten Antrieb im Roboter.

Bei einer Ausführungsform der Erfindung umfasst also der Endeffektor selbst Aktoren zur Feinjustierung der Zielposition.

Auch der Roboter selbst kann, wie es bei einer Ausführungsform der Erfindung vorgesehen ist, über die Bilderkennung mittels der Kamera in seinem Bewegungsablauf feinjustiert werden.

Die Kamera kann ferner auch zur ständigen Anlagenüberwachung verwendet werden sowie zur Überwachung des Raums auf Hindernisse.

Alles in allem kann durch die Verwendung der Kamera insbesondere das Teach-in eines Roboters in erheblicher Weise vereinfacht werden.

### Bezugszeichenliste

- 1: System zur Prozessierung von Halbleiterbauelementen
- 2: Endeffektor
- 3a, 3b: Arm des Endeffektors
- 4: Aufnahme
- 5: Maske/Wafer
- 6: Tablet
- 7, 7a, 7b: Kamera
- 8a, 8b: Ansicht
- 9: Beleuchtung
- 10: Anlage zur Prozessierung von Halbleiterbauelementen
- 11: Behälter mit (nicht dargestellter) Aufnahme
- 12: Roboter
- 13: Bearbeitungsstation
- 14: Wafer-Inspektionsgerät
- 15: Kameragehäuse
- 16: Ecke
- 17: Einbuchtung
- 18: verfahrbare Bühne (Stage)
- 19: Platte
- 20: Isolator

## Patentansprüche

1. Verfahren zum Anlernen und/oder Kontrollieren eines Roboters zum Bewegen eines Wafers oder einer Maske, oder eines Flat-Panel-Displays, wobei zumindest eine Kamera verwendet wird, die die Bewegung des Roboters und/oder des Wafers oder der Maske oder des Flat-Panel-Displays aufnimmt, vorzugsweise mittels Erkennung des Wafers, der Maske, oder des Flat-Panel-Displays, und/oder der Erkennung der Auflage des Wafers, der Maske oder des Flat-Panel-Displays, und/oder der Erkennung von Markierungen in Anlagen der Prozessierung von Wafern, Masken oder Flat-Panel-Displays durch mindestens eine Kamera.

2. Verfahren nach dem vorstehenden Anspruch, **dadurch gekennzeichnet, dass** mit der Kamera die aktuelle Position und/oder die Zielposition des Wafers, der Maske, oder des Flat-Panel-Displays auf einer Aufnahme, insbesondere auf einem Chuck oder einer anderen Station, kontrolliert wird.

3. Verfahren nach Anspruch 1, **dadurch gekennzeichnet,**
**dass** die zumindest eine Kamera an einem Arm des Roboters, insbesondere an einem Endeffektor angebracht wird.

4. Verfahren nach einem der vorstehenden Ansprüche,
**dadurch gekennzeichnet, dass** die Kamera für einen Teach-In Vorgang verwendet wird, insbesondere dass der Teach-In Vorgang automatisiert unter Verwendung der Kamera ausgeführt wird.

5. Verfahren nach einem der vorstehenden Ansprüche,
**dadurch gekennzeichnet, dass** die Kamera auf zumindest eine Kante und/oder auf zumindest den teilweisen, insbesondere vollständigen, Umriss des Wafers oder der Maske oder des Flat-Panel-Displays beim Ablegen oder Aufnehmen des Wafers oder der Maske oder des Flat-Panel-Displays gerichtet wird.

6. Verfahren nach einem der vorstehenden Ansprüche,
**dadurch gekennzeichnet, dass** das Bild der Kamera auf ein Display, insbesondere auf ein Display eines tragbaren elektronischen Geräts, übertragen wird, und/oder dass die zumindest eine Kamera nur temporär angebracht wird, insbesondere unter Verwendung einer werkzeuglos anbringbaren Befestigung,
und/oder dass zumindest zwei Kameras verwendet werden.

7. Verfahren nach einem der vorstehenden Ansprüche,
**dadurch gekennzeichnet, dass** mit der zumindest einen Kamera ein Versatz zu einer Sollposition oder eine Position des Wafers oder der Maske oder des Flat-Panel-Displays gemessen wird.

8. Verfahren nach einem der vorstehenden Ansprüche,
**dadurch gekennzeichnet, dass** die Kamera zur Prozesskontrolle, insbesondere zur fortlaufenden Kontrolle einer Zielposition, verwendet wird, und/oder dass die zumindest eine Kamera vorzugsweise stationär montiert ist.

9. Verfahren nach einem der vorstehenden Ansprüche,
**dadurch gekennzeichnet, dass** mittels der Kamera das Teach-In des Roboters, vorzugsweise automatisch, während des Betriebs fortlaufend nachjustiert wird, vorzugsweise bei Überschreitung zumindest eines Grenzwerts und/oder gesteuert durch ein übergeordnetes Steuerungssystem und/oder manuell durch einen Bediener.

10. Verfahren nach einem der vorstehenden Ansprüche,
**dadurch gekennzeichnet, dass** die Kamera verwendet wird, um Kollisionen mit Hindernissen im Bewegungsraum des Roboters zu vermeiden.

11. Verfahren nach einem der vorstehenden Ansprüche,
**dadurch gekennzeichnet, dass** die Kamera in einer Vakuumkammer installiert wird und/oder dass das Bild der zumindest einen Kamera drahtlos übertragen wird, und/oder dass die durch die Kamera aufgenommenen Daten, oder darauf basierend durch eine Bildverarbeitung bearbeiteten Daten und/oder weiterverarbeiten Daten, Reaktionen in der Anlage initiieren und/oder an ein der Anlage übergeordnetes Steuerungssystem gesendet werden, insbesondere um die Anlage durch ein übergeordnetes Steuersystem zu überwachen,
und/oder dass ein Endeffektor verwendet wird, bei welchem die Positionierung der Maske, des Wafers oder des Flat-Panel-Displays auf die Aufnahme durch im Endeffektor integrierte Motoren, insbesondere Piezos, erfolgt,
und/oder dass ein Kameramodul mit einer integrierten Beleuchtung und/oder eine Infrarotkamera verwendet wird, wobei insbesondere mittels der Infrarotkamera die Temperatur der Maske, des Wafers oder des Flat-Panel-Displays oder deren Umgebungen gemessen wird.

12. Verfahren nach einem der vorstehenden Ansprüche,
**dadurch gekennzeichnet, dass** mittels einer automatisierten Bildverarbeitung eine Position des Wafers oder der Maske oder eines Flat-Panel-Displays bestimmt wird, und/oder dass Abstände zwischen Wafern, Masken oder Flat Panel Displays, und/oder Auflagen, und/oder Markierungen, und/oder Armen des Endeffektors gemessen werden.

13. Verfahren, insbesondere nach einem der vorstehenden Ansprüche, **dadurch gekennzeichnet, dass** mittels einer zumindest einen Kamera überprüft wird, ob ein Wafer, eine Maske oder Flat-Panel-Display auf einer Aufnahme und/oder einem Endeffektor vorhanden ist, wobei die Überprüfung vorzugsweise erfolgt, ohne mit weiteren Sensoren zusammenzuwirken, und/oder dass mittels der zumindest einen Kamera die Belegung eines Behälters, insbesondere einer Kassette, oder einer Auflage, mit Substraten eines Wafers, einer Maske oder eines Flat-Panel-Displays ermittelt wird.

14. Verfahren nach einem der vorstehenden Ansprüche,
**dadurch gekennzeichnet, dass** mittels der zumindest einen Kamera überprüft wird, auf welcher Seite oder in welcher Orientierung sich ein Pellicle der Maske befindet.

15. System, ausgebildet zur Ausführung eines Verfahrens nach einem der vorstehenden Ansprüche, wobei das System vorzugsweise zumindest eine Kamera umfasst, die auf einen Auflagepunkt eines Wafer- oder Maskensubstrats oder eines Flat-Panel-Displays, oder auf eine Markierung, oder auf eine Arm eines Endeffektors gerichtet ist.

16. System dem vorstehenden Anspruch, **dadurch gekennzeichnet, dass** sich die zumindest eine Kamera an einem Endeffektor und/oder an einer Aufnahme des Wafer- oder Maskensubstrats oder eines Flat-Panel-Displays und/oder im Chuck und/oder in einer Station, insbesondere Bearbeitungsstation des Systems, befindet.
